Europäisches Patentamt

European Patent Office

Office européen des brevets

(19)

(11) Veröffentlichungsnummer: **0 224 887 B1**

# (12) EUROPÄISCHE PATENTSCHRIFT

(45) Veröffentlichungstag der Patentschrift: **11.03.92**

(51) Int. Cl.⁵: **H01L 27/02**, G11C 11/40

(21) Anmeldenummer: **86116579.3**

(22) Anmeldetag: **28.11.86**

(54) **Gate Array Anordnung in CMOS-Technik.**

(30) Priorität: **06.12.85 DE 3543212**

(43) Veröffentlichungstag der Anmeldung:
**10.06.87 Patentblatt 87/24**

(45) Bekanntmachung des Hinweises auf die Patenterteilung:
**11.03.92 Patentblatt 92/11**

(84) Benannte Vertragsstaaten:
**AT BE CH DE FR GB IT LI LU NL SE**

(56) Entgegenhaltungen:
EP-A- 0 119 059
EP-A- 0 131 463
DE-A- 3 206 507

PATENTS ABSTRACTS OF JAPAN; vol. 7, no. 251 (E-209)[1396], 8th November 1983; & JP-A-58 139 446

IDEM

PATENTS ABSTRACTS OF JAPAN, vol. 7, no. 154 (E-185)[1299], 6th July 1983; JP-A-58064 047

PATENTS ABSTRACTS OF JAPAN, vol. 9, no. 219 (E-410)[1942], 6th September 1985; JP-

A-60 80 251

PATENTS ABSTRACTS OF JAPAN; vol. 9, no. 201 (E-336)[1924], 17th August 1985; JP-A-60 66 447

PATENTS ABSTRACTS OF JAPAN, vol. 9, no. 178 (E-330)[1901], 23rd July 1985; & JP-A-60 47 440

(73) Patentinhaber: **SIEMENS AKTIENGESELL-SCHAFT**
**Wittelsbacherplatz 2**
**W-8000 München 2(DE)**

(72) Erfinder: **Holzapfel, Heinz Peter**
**Blütenstrasse 14**
**W-8000 München 40(DE)**
Erfinder: **Michel, Petra**
**Am Voglherd**
**W-8018 Grafing(DE)**

## Beschreibung

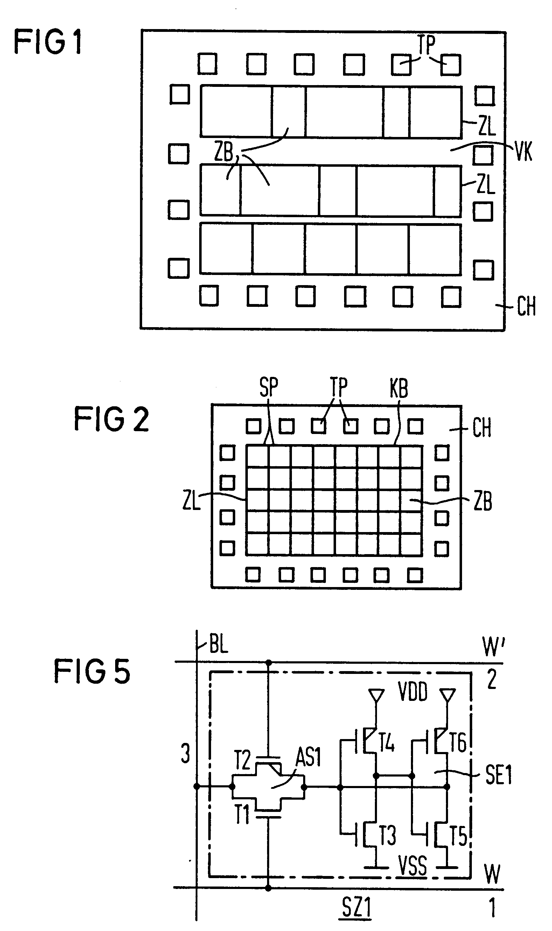

Gate Array Anordnungen sind bekannt (z. B. Hitachi Review Vol. 33 (1984) Nr. 5, Seite 261 bis 266). Bei solchen Gate Array Anordnungen werden auf einem Chip Zellbereiche oder Zellen in bestimmter Anordnung vorgesehen, auf denen Grundschaltungen realisiert sind. Ein Beispiel einer solchen Gate Array Anordnung zeigt Fig. 1. Hier sind die Zellbereiche ZB in einem Kernbereich KB eines Chips CH in Zeilen ZL angeordnet. Zwischen Zeilen ZL liegen Verdrahtungskanäle VK. Außerhalb des Kernbereiches des Chips können Anschlußstellen TP und Schaltungen angeordnet sein, die nicht mit Hilfe der Grundschaltungen realisiert werden können.

Die Grundschaltungen bestehen aus N-Kanal- und P-Kanaltransistoren, die in bestimmter Weise in den Zellbereichen ZB angeordnet sind. Durch Verbindung der N- und P-Kanaltransistoren pro Grundschaltung kann die Grundschaltung zur Realisierung einer Grundfunktion spezifiziert werden und ihr z. B. eine logische Funktion oder eine Speicherfunktion gegeben werden. Aus Hitachi Review, die oben zitiert worden ist, ergibt sich, daß eine Grundschaltung z. B. aus 10 Transistoren bestehen kann, die so miteinander verbunden werden, daß eine RAM-Speicherzelle mit einem Eingang oder zwei Eingängen entsteht. Durch andere Verbindungen der Transistoren in einer Grundschaltung kann z. B. eine logische Funktion, z. B. die NAND-Funktion realisiert werden.

Die einzelnen Grundschaltungen in der Gate Array Anordnung müssen zur Einstellung von Funktionen untereinander verbunden werden. Dies geschieht dann über Verdrahtungskanäle VK, die zwischen den Zeilen ZL angeordnet werden oder die auch über den Zeilen ZL von Grundschaltungen verlaufen können.

Die Realisierung von Speichern unterschiedlicher Kapazität wurde bisher auf verschiedene Art erreicht. Für speichernde Strukturen kleiner Kapazität wurden bistabile Schaltungen verwendet. Diese sind aus mehreren Gattern zusammengesetzt und benötigen deshalb verhältnismäßig viele Grundschaltungen eines Gate Arrays zur Speicherung einer Informationseinheit. Speicher große Kapazität wurden dadurch realisiert, daß ein als allgemeine Zelle entworfener Speicherblock definierter Kapazität in den Kernbereich des Chips eingebaut wurde. Dies führte dazu, daß die Kapazität eines Speichers nur in Schritten der Speicherkapazität dieser allgemeinen Zelle gewählt werden kann. Schließlich war der Platzbedarf für solche Speicher verhältnismäßig groß, da Verdrahtungskanäle zwischen den Zeilen von Zell-Bereichen angeordnet werden mußten.

In den "Patent Abstracts of Japan", Vol. 7, No. 251, (E-209), (1396), in der Patentschrift JP-A-58-139446, in den "Patent Abstracts of Japan", Vol. 9, No. 219, (E-410), (1942), in der Patentschrift JP-A-60-80251, und in der Patentschrift EP-A-0 119 059 ist jeweils eine Anordnung für ein Grundelement angegeben, welches auf einem Chip matrixartig in Zeilen und Spalten angeordnet werden kann, und welches aus einer gleichen Anzahl von N-Kanaltransistoren und P-Kanaltransistoren aufgebaut ist, welche entweder zu einer Speicherzelle oder zu einer logischen Zelle verdrahtet werden können. In der Offenlegungsschrift DE-A-320 6507 sind mehrere Schaltungen für statische Direktzugriffsspeicher angegeben.

Die der Erfindung zugrundeliegende Aufgabe besteht darin, eine weitere Gate Array Anordnung anzugeben, bei der Grundschaltungen vorgesehen sind, durch die sowohl logische Elemente als auch speichernde Elemente realisiert werden können.

Diese Aufgabe wird bei einer Gate Array Anordnung durch die im Kennzeichen des Anspruches 1 angegebenen Merkmale gelöst.

Durch eine matrixartige Anordnung der Zellenbereiche im Kernbereich des Chips ist es möglich, auf dem Chip eine große Anzahl von solchen Grundschaltungen zu realisieren. Für die Verdrahtungskanäle sollen dabei keine besonderen Bereiche mehr auf dem Chip vorgesehen sein. Die Verdrahtung erfolgt entweder über Grundschaltungen oder es werden zur Verdrahtung Grundschaltungen verwendet. Bei einem derartigen Aufbau der Gate Array Anordnung können bei Zusammenschaltung der Transistoren einer Grundschaltung zu einer Speicherzelle Speicherkapazitäten flexibel gestaltet werden.

Die erfindnungsgemäße Ausführungsform der Grundschaltung besteht aus drei P-Kanaltransistoren und 4 N-Kanaltransistoren bestehen. Die 3 P-Kanaltransistoren liegen in Zeilenrichtung nebeneinander und haben gleiche Kanalweite, 3 der N-Kanaltransistoren liegen in Zeilenrichtung nebeneinander und haben ebenfalls gleiche Kanalweite. Jeweils 3 N-Kanaltransistoren und 3 P-Kanaltransistoren liegen in Spaltenrichtung übereinander, der vierte N-Kanaltransistor liegt außerhalb des durch die 3 P-Kanaltransistoren und die 3 N-Kanaltransistoren gebildeten Bereiches der Grundschaltung und hat eine kleine Kanalweite.

Mit diesen Grundschaltungen können Speicherzellen realisiert werden, die nur eine einzige Eingangsleitung haben, über die eingeschrieben und ausgelesen wird.

Andere Weiterbildungen ergeben sich aus den Unteransprüchen.

Anhand von Ausführungsbeispielen, die in den Figuren 10-14 dargestellt sind, wird die Erfindung weiter erläutert. Die Figuren 1 - 9 sind nicht Teil der Erfindung.

Es zeigen

Fig. 1     eine bekannte Gate Array Anordnung,

Fig. 2     eine Gate Array Anordnung nach dem Matrixtyp,

Fig. 3     eine erste Grundschaltung aus 6 Transistoren,

Fig. 4     eine zweite Grundschaltung aus 6 Transistoren,

Fig. 5     eine Realisierung einer Speicherzelle mit Hilfe von 6 Transistoren,

Fig. 6     die Spezifizierung der Grundschaltungen 1 und 2 zu einer Speicherzelle gemäß Fig. 5,

Fig. 7     ein Schnitt durch die Speicherzelle der Fig. 6

Fig. 8     ein Zeitdiagramm, das den Schreibvorgang bei der Speicherzelle nach Fig. 5 zeigt,

Fig. 9     eine Schaltung zum Ansteuern eines Speichers aus Speicherzellen gem. Fig. 5,

Fig. 10     eine erfindungsgemäße Ausführungsform der Grundschaltung aus 7 Transistoren,

Fig. 11     eine zweite Speicherzelle mit 7 Transistoren,

Fig. 12     die Spezifizierung der Ausführungsform der Grundschaltung gemäß der Speicherzelle von Fig. 11,

Fig. 13     eine Schaltung zur Ansteuerung eines aus den Speicherzellen nach Fig. 10 bestehenden Speichers,

Fig. 14     die Realisierung eines Festspeichers mit Hilfe der Speicherzellen nach Fig. 11.

Aus Fig. 2 ergibt sich eine Gate Array Anordnung, bei der auf einem Chip CH Zellbereiche für die Grundschaltungen in Form einer Matrix angeordnet sind, die aus Zeilen ZL und Spalten SP besteht. Die Matrix füllt den gesamten Kernbereich KB des Chips CH aus. Am Rande des Chips CH können Schaltungen angeordnet werden, die mit Hilfe der Grundschaltungen nicht realisierbar sind oder es werden dort die Anschlußstellen TP aufgebracht.

Ein Vergleich der Fig. 2 mit der Fig. 1 zeigt, daß bei der Gate Array Anordnung nach Fig. 2 im Kennbereich ausschließlich Grundschaltungen vorgesehen sind. Besondere Verdrahtungskanäle wie bei Fig. 1 gibt es nicht mehr. Damit entfällt auch der Platzbedarf für solche Verdrahtungskanäle.

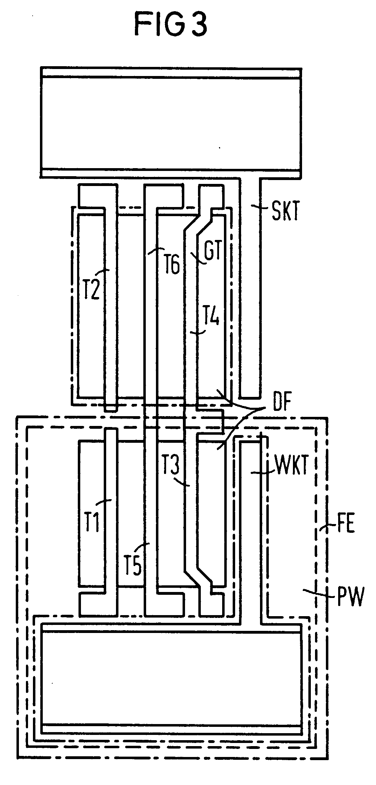

Die Grundschaltungen in den Zellbereichen ZB können z. B. aus sechs Transistoren nach Fig. 3 bestehen. Dabei sind 3 N-Kanaltransistoren T1, T3, T5 und 3 P-Kanaltransistoren T2, T4, T6 vorgesehen. Sowohl die N-Kanaltransistoren als auch die P-Kanaltransistoren sind nebeneinander in Zeilenrichtung der Zellenbereichsmatrix angeordnet. In Spaltenrichtung der Matrix liegt jeweils ein P-Kanal- und ein N-Kanaltransistor übereinander. Der Gateanschluß des P-Kanaltransistors T6 und des N-Kanaltransistors T5 bzw. des P-Kanaltransistors T4 und des N-Kanaltransistors T3 ist jeweils miteinander verbunden.

Die weiteren in Fig. 3 dargestellten Strukturen sind bekannt und werden darum nur aufgezählt. Mit DF sind die Diffusionsgebiete der Transistoren angegeben, mit GT die Gatebereiche, mit PW die P-Wanne für die N-Kanaltransistoren, mit FE die Feldimplantation, mit WKT der Wannenkontakt und mit SKT ein Substratkontakt. Mit VDD bzw. VSS sind Leiterbahnen für die Potentiale VDD und VSS bezeichnet.

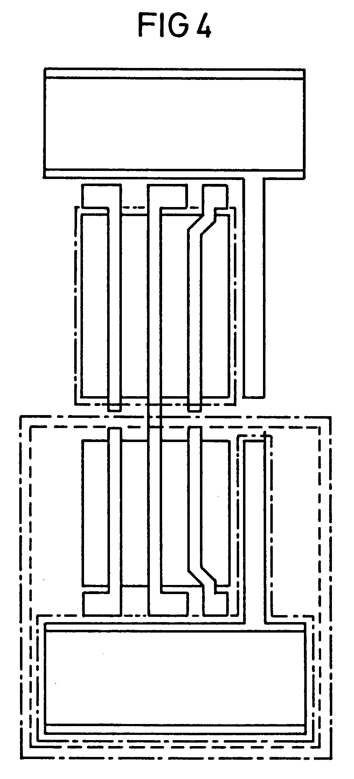

Fig. 4 zeigt eine zweite Ausführungsform der Grundschaltung. Diese unterscheidet sich von der Ausführungsform der Fig. 3 nur dadurch, daß der P-Kanaltransistor T4 und der N-Kanaltransistor T3 keinen gemeinsamen Gateanschluß aufweisen. Diese Ausführungsform ist besonders zur Realisierung von Festspeichern geeignet.

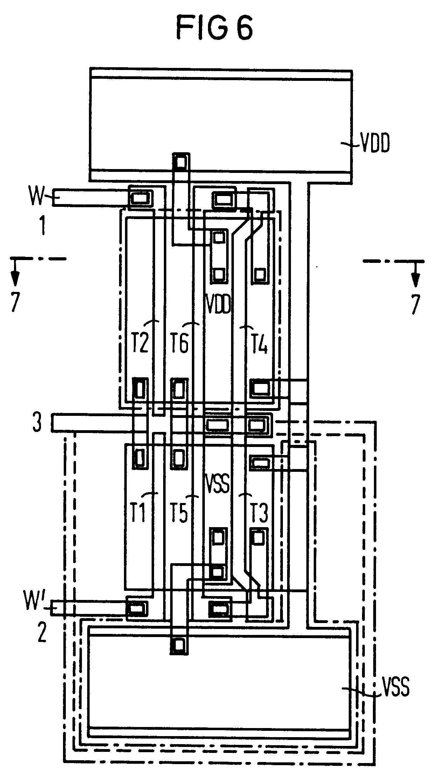

Eine Schaltung einer SRAM-Speicherzelle SZ, die besonders für die Grundschaltungen der Fig. 3 oder Fig. 4 geeignet ist, ergibt sich aus Fig. 5. Die Speicherzelle SZ besteht aus einem Speicherelement SE1 mit den Transistoren T3, T4, T5, T6 und aus einer Ansteuerschaltung AS1 mit den Transistoren T1 und T2. Das Speicherelement der Fig. 5 ist aus dem Stand der Technik bekannt, z. B. aus H. Weiß, K. Horninger, Integrierte MOS-Schaltungen, Springer-Verlag 1982, Seite 229. Die Ansteuerschaltung unterscheidet sich dagegen vom Stand der Technik. Sie besteht aus dem N-Kanaltransistor T1 und dem P-Kanaltransistor T2, deren Source-Drain Strecken parallel geschaltet sind. Der Gateanschluß des P-Kanaltransistors T2 ist mit einer Ansteuerleitung W′, der Gateanschluß des N-Kanaltransistors ist mit einer Ansteuerleitung W verbunden. Die Parallelschaltung der Source-Drain Strecken der Transistoren T1 und T2 liegt zwischen einer Bitleitung BL und dem gemeinsamen Gateanschluß des Transistorpaares T3, T4.

Die angegebene Ausführung der Ansteuerschaltung AS1 hat den Vorteil, daß beim Einspeichern einer Information in das Speicherelement SE1 bzw. beim Auslesen einer Information aus dem Speicherelement SE1 die geeigneten Transistoren T1 und T2 leitend gesteuert werden können. Beim Schreiben in die Speicherzelle wird sowohl ein Ansteuersignal auf die Leitung W als auch auf die Leitung W′ gegeben und damit beide Transistoren T1 und T2 leitend gesteuert. Damit ist es möglich, das Speicherelement SE1 entsprechend der Information auf der Bitleitung BL schnell umzuladen. Beim Auslesen einer Information aus dem Speicherelement SE1 muß dagegen verhindert werden, daß die im Speicherelement SE1 enthaltene Information gestört wird. Aus diesem Grund wird nur der P-Kanaltransistor T2 leitend gesteuert, der einen verhältnismäßig großen Widerstand beim Auslesen bildet.

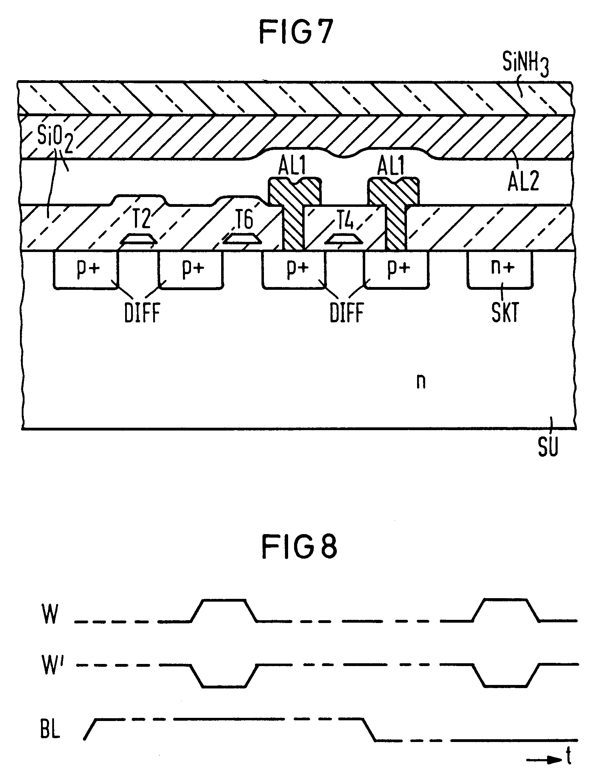

Die Zeitverhältnisse beim Einschreiben einer Information in die Speicherzelle nach Fig. 5 zeigt das Zeitdiagramm der Fig. 8. Es sind die Signale auf den Ansteuerleitungen W und W' und das Signal auf der Bitleitung BL aufgetragen über der Zeit t dargestellt. Es ist zu sehen, daß zunächst die einzuschreibende Information an die Bitleitung BL angelegt wird und diese entsprechend umgeladen wird und daß dann an die beiden Ansteuerleitungen W und W' Signale angelegt werden, durch die die Transistoren T1 und T2 leitend gesteuert werden. Beim Lesevorgang dagegen wird nur ein Ansteuersignal auf die Leitung W' gegeben und damit der P-Kanaltransistor T2 leitend gesteuert.

Die Spezifizierung z. B. der Grundschaltung nach Fig. 3 entsprechend der Speicherzelle nach Fig. 5 ergibt sich aus Fig. 6. In Fig. 6 sind die Transistoren T1 bis T6 so bezeichnet wie in Fig. 5 bei der Speicherzelle. Weiterhin sind Ziffern angegeben, die den Ziffern in Fig. 5 entsprechen. Es ist leicht zu erkennen, wie die einzelnen Transistoren verbunden sind und wie die Transistoren T4 und T6 an ein Potential VDD bzw. die Transistoren T3 und T5 an ein Potential VSS angeschlossen sind. Die Daten werden jeweils über den Eingang 3 in das Speicherelement SE1 eingeschrieben oder über den Eingang 3 auf die Bitleitung BL ausgelesen.

In Fig. 7 ist zur weiteren Erläuterung ein Schnitt durch die Speicherzelle der Fig. 6 gezeigt. Die ganze Struktur ist in einem N-Substrat SU angeordnet. Die P-Kanaltransistoren T2, T6, T4 liegen nebeneinander. Das Diffusionsgebiet DIFF des Transistors T6 und T4 ist mit einer Leitung AL1 aus Aluminium verbunden. Entsprechendes gilt für das andere Diffusionsgebiet des Transistors T4. Oberhalb der Transistoren ist eine weitere Leitung AL2 aus Aluminium geführt, über die z. B. eine Verdrahtung von Grundschaltungen oder Speicherzellen miteinander erfolgt. Der weitere Aufbau der Speicherzelle ergibt sich aus Fig. 7 und muß nicht weiter erläutert werden.

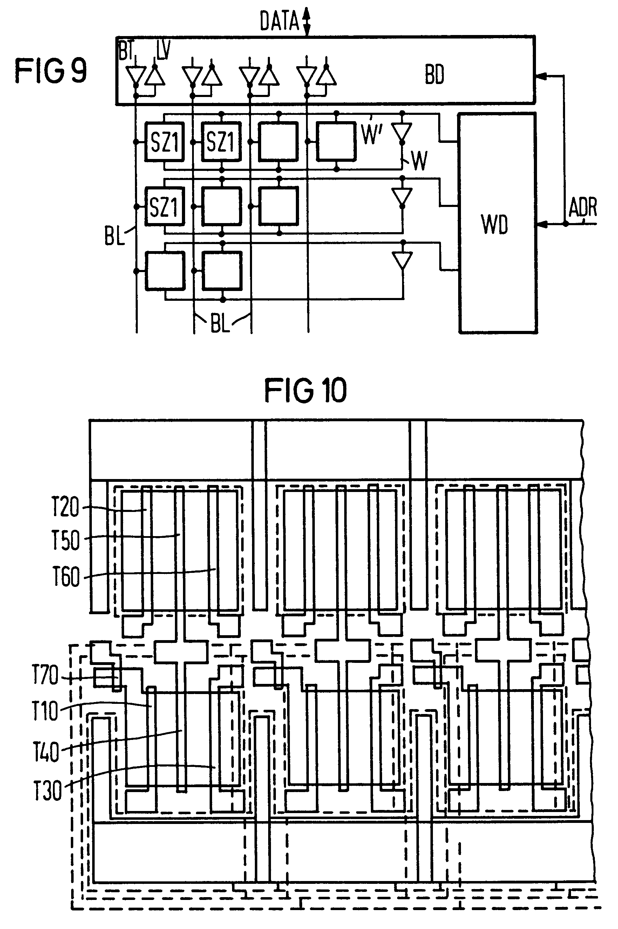

Aus Fig. 9 ergibt sich anhand eines Prinzipschaltbildes wie die auf dem Chip vorgesehenen als Speicherzellen SZ spezifizierten Grundschaltungen zu einem Speicher zusammengeschaltet werden können. Jede Bitleitung BL ist mit einem Bitleitungstreiber BT und einem Leseverstärker LV verbunden. Je nach dem, ob eine Information in den Speicher eingeschrieben wird bzw. eine Information aus dem Speicher ausgelesen wird ist der Bitleitungstreiber BT bzw. der Leseverstärker LV aktiv. Die Leseverstärker bzw. Bitleitungstreiber und weitere Bitleitungsdecoder BD sind am Rande des Speichers angeordnet und sind ebenfalls mit Hilfe der Grundschaltungen realisiert. Die erste und die zweite Ansteuerleitung W, W' führt zu einem Wortleitungsdecoder WD, über den gewünschte Zeilen von Speicherzellen ausgewählt werden. Die Auswahl erfolgt mit Hilfe einer Adresse ADR, die zudem zur Auswahl der Bitleitungen verwendet wird.

Aus Fig. 10 ergibt sich eine dritte Ausführungsform der Grundschaltung. Diese besteht aus 7 Transistoren, und zwar 4 N-Kanaltransistoren und 3 P-Kanaltransistoren. Die P-Kanaltransistoren sind mit T20, T50, T60 bezeichnet und haben alle gleiche Kanalweite. Drei der N-Kanaltransistoren, und zwar die mit T10, T30, T40 bezeichneten Transistoren haben gleiche Kanalweite, während der vierte N-Kanaltransistor T70 eine sehr viel kleinere Kanalweite hat.

Die P-Kanaltransistoren und die N-Kanaltransistoren T10, T30, T40 liegen jeweils in Zeilenrichtung der Matrix nebeneinander. In Spaltenrichtung liegen jeweils ein N-Kanal und ein P-Kanaltransistor übereinander. In der Ausführungsform gemäß Fig. 10 ist ein Gateanschluß des P-Kanaltransistors T50 mit dem Gateanschluß des N-Kanaltransistors T40 verbunden. Die weiteren Strukturen, die sich aus Fig. 10 ergeben, sind bekannt und werden nicht weiter erläutert.

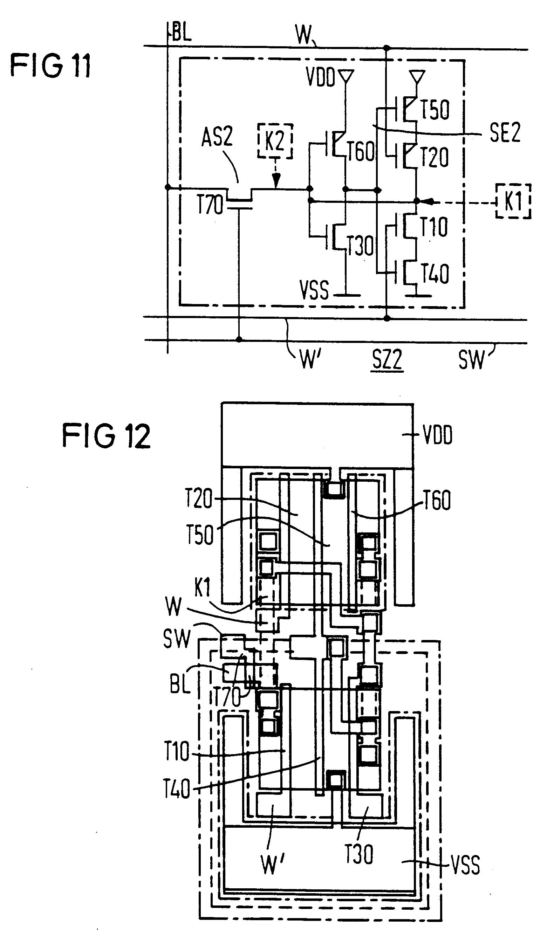

Mit Hilfe der Grundschaltung aus sieben Transistoren gemäß Fig. 10 kann eine Speicherzelle SZ2 realisiert werden, wie sie in Fig. 11 gezeigt ist. Die Speicherzelle besteht aus einem Speicherelement SE2 und einer Ansteuerschaltung AS2. Das Speicherelement unterscheidet sich vom Speicherelement der Fig. 5 dadurch, daß noch zwei zusätzliche Transistoren T10 und T20 vorgesehen sind, die jetzt mit der Ansteuerleitung W und W' verbunden sind. Die Ansteuerschaltung dagegen besteht aus einem einzigen Transistor T70, nämlich dem Transistor mit der kleinen Kanalweite.

Der Transistor T70 arbeitet als Datentransfertransistor, der abhängig von einem Auswahlsignal auf einer Auswahlleitung SW die Information in dem Speicherelement SE2 auf die Bitleitung BL schaltet oder umgekehrt. Soll Information in das Speicherelement eingeschrieben werden, dann werden durch Signale auf den Schreibleitungen W und W' die Transistoren T10 und T20 gesperrt, so daß der innere Knoten K1 zunächst seine Ladung behält. Der Datentransfertransistor T70 wird leitend gesteuert. Falls die Bitleitung in einem hochohmigen Zustand ist, behält auch der Knoten K2 den größten Teil seiner gespeicherten Ladung; ist die Bitleitung BL in einem niederohmigen Zustand, so wird der Knoten K2 umgeladen. Verschwindet das Schreibsignal auf den Schreibleitungen W und W' wieder, dann gehen die Transistoren T10 und T20 in den leitenden Zustand über und die Transistoren T50 und 140 laden aufgrund der am Knoten K2 gespeicherten Ladung den Knoten K1 um. Anschließend kann das Auswahlsignal SW wieder abgeschaltet werden und der Datentransfertransistor T70 geht in den Sperrzustand über.

Die Schaltung der Speicherzellen nach Fig. 11 hat gegenüber der Speicherzelle der Fig. 5 den Vorteil, daß aufgrund der Transistoren T10 und T20 nicht gegen das Speicherelement eingeschrieben werden muß, so daß der Einschreibvorgang schneller und zuverlässiger erfolgt und auch weniger starke Bitleitungstreiber ausreichend sind.

Die Spezifizierung der Grundschaltung nach Fig. 10 entsprechend der Speicherzelle nach Fig. 11 ist in Fig. 12 gezeigt. Aus der Figur ist gut erkennbar, wie die Transistoren miteinander verbunden sind. Weiter zeigt Fig. 12, wie Transistor T60 bzw. T30 mit dem Potential VDD bzw. VSS verbunden ist und wie die Auswahlleitung SW und die Bitleitung BL mit dem Datentransfertransistor T70 verbunden ist. Über die Bitleitung BL erfolgt sowohl das Einschreiben einer Information als auch das Auslesen einer Information.

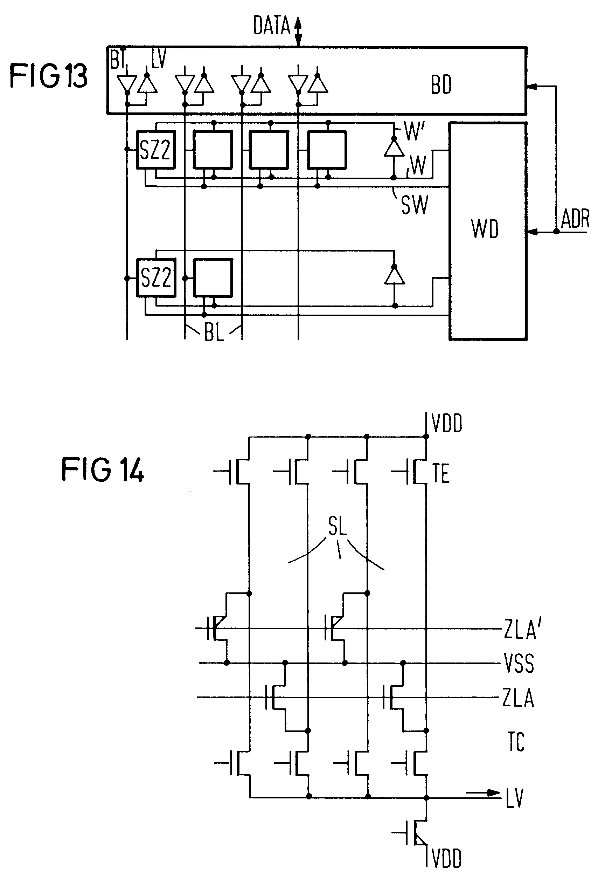

Den prinzipiellen Aufbau eines Speichers mit Hilfe der Speicherzellen SZ2 der Fig. 11 ergibt sich aus Fig. 13. Der Unterschied zum Speicher der Fig. 9 besteht darin, daß hier zusätzlich die Auswahlleitung SW zu den Schreibleitungen W und W' notwendig ist. An den Bitleitungen liegen wiederum Bitleitungstreiber Bt und Leseverstärker LV zum Einschreiben einer Information oder zum Auslesen einer Information. Die Auswahl der Bitleitungen und der Schreib- und Auswahlleitungen erfolgt mit Hilfe einer Adresse ADR, die an den Bitleitungsdecoder BD und an den Wortleitungsdecoder WD angelegt wird.

Die Grundschaltungen gemäß Fig. 10 können auch zur Realisierung eines Festspeichers (ROM) benutzt werden. Mit der Ausführungsform der Fig. 10 können ebenfalls vier Speicherelemente pro Grundschaltung realisiert werden.

Für Fig. 14 zeigt die Spezifizierung der Grundschaltung als 4-Bit-ROM-Zelle, wobei die Spezifizierung über Diffusionskontakte oder über Gatekontakte erfolgen kann. Das Funktionsprinzip der Schaltung besteht darin, daß die Spaltenleitungen SL in einem Ladetakt über Vorladetransistoren TE vorgeladen werden, daß dann an die Zeilenleitungen ZLA oder ZLA' Lesesignale angelegt werden und schließlich durch Spaltenauswahltransistoren TC die Bewertung der Spaltenleitungen mit Hilfe von Leseverstärkern erfolgt. Durch die Signale auf den Zeilenleitungen ZLA bzw. ZLA' wird die entsprechende Spaltenleitung nur dann entladen, wenn das Gate des am Kreuzungspunkt von Spalten und Zeilenleitungen angeordneten Transistors (wie in Fig.14) an die Zeilenleitung angeschlossen ist oder die Source des Transistors an der Spaltenleitung SL angeschlossen ist. Ist dies nicht der Fall, dann wird die entsprechende Spaltenleitung nicht entladen.

Die Programmierung der Speicherzellen kann somit über Gatekontaktierungen mit den Zeilenleitungen ZLA oder ZLA', durch Anlegen eines binär 0 oder binär 1 entsprechenden Potentials an die Gateanschlüsse oder durch Kontaktieren oder Nichtkontaktieren des Source-Anschlußes der Transistoren an die Spaltenleitungen bei mit den Zeilenleitungen verbundenen Gateanschlüssen erfolgen. Da die Grundschaltungen sowohl P-Kanaltransistoren als auch N-Kanaltransistoren enthalten, die als Speicherelemente verwendbar sind, muß das Zeilenauswahlsignal der Zeilenleitung ZLA' invertiert, der Zeilenleitung ZLA nichtinvertiert zugeführt werden.

**Patentansprüche**

1. Gate Array-Anordnung mit folgenden Merkmalen:
   - auf einem Chip sind Zellbereiche (ZB) matrixartig in Zeilen (ZL) und Spalten (SP) angeordnet, wobei die Zellbereiche unmittelbar nebeneinander liegen,
   - in jedem Zellbereich (ZB) ist eine Grundschaltung aus N-Kanal- und P-Kanaltransistoren ausgebildet,
   - jede Grundschaltung besteht aus drei Transistoren des einen Leitungstyps (T20, T50, T60) und vier Transistoren (T10, T30, T40, T70) des entgegengesetzten Leitungstypes,
   - die drei Transistoren des einen Leitungstyps (T20, T50, T60) liegen in Zeilenrichtung nebeneinander und haben gleiche Kanalweite,
   - drei der Transistoren (T10, T30, T40) des entgegengesetzten Leitungstyps liegen in Zeilenrichtung nebeneinander und haben gleiche Kanalweite,
   - in Spaltenrichtung liegt jeweils ein Transistor des einen Leitungstyps und ein Transistor des anderen Leitungstyps nebeneinander,
   - der vierte Transistor (T70) des entgegengesetzten Leitungstyps weist eine kleinere Kanalweite als die drei Transistoren des entgegengesetzten Leitungstyps (T10, T30, T40) auf und liegt außerhalb des durch die drei Transistoren des einen-Leitungstyps und die drei Transistoren des entgegengesetzten Leitungstyps eingenommenen Bereichs der Grundschaltung,
   - in vorgegebenen Grundschaltungen sind die jeweiligen Transistoren zur Spezifizierung entsprechend der zu realisierenden Grundfunktion als logische Zelle oder als Speicherzelle miteinander verbunden,

- die Grundschaltungen sind entsprechend der zu realisierenden Gesamtfunktion als logische Schaltung oder Speicher miteinander verdrahtet, und
- die Verdrahtung der Grundschaltungen erfolgt entweder über spezifizierte Grundschaltungen oder über nicht spezifizierte Grundschaltungen.

2. Anordnung nach Anspruch 1,
dadurch **gekennzeichnet,**
daß die Transistoren des einen Leitungstyps p-Kanal-Transistoren sind, die Transistoren des anderen Leitungstyps n-Kanaltransistoren.

3. Anordnung nach Anspruch 1 oder 2,
dadurch **gekennzeichnet,**
daß die Gateanschlüsse von einem der in Spaltenrichtung nebeneinander liegenden Transistorpaare (T40, T50) miteinander verbunden sind.

4. Anordnung nach einem der Ansprüche 1 bis 3,
**gekennzeichnet** durch folgende Merkmale:
a) die Transistoren wenigstens einer der Grundschaltungen sind zu einer Speicherzelle (SZ2) bestehend aus einem Speicherelement (SE2) und einem Datentransfertransistor (AS2) zusammengeschaltet,
b) das Speicherelement (SE2) besteht aus einem Transistorpaar aus einem P-Kanaltransistor (T60) und einem N-Kanaltransistor (T30) und einer Transistorschaltung aus einem ersten und zweiten P-Kanaltransistor (T20, T50) und einem dritten und vierten N-Kanaltransistor (T10, T40), die folgendermaßen geschaltet sind,
- der gemeinsame Gateanschluß des Transistorpaares (T30, T60) ist mit dem Verbindungspunkt (K1) der gesteuerten Strecken des ersten und dritten Transistors (T10, T20) verbunden,
- der gemeinsame Gateanschluß der zweiten und vierten Transistoren (T40, T50) ist mit dem Verbindungspunkt der gesteuerten Strecken des Transistorpaares (T30, T60) verbunden,
- die anderen Anschlüsse der gesteuerten Strecke des Transistorpaares (T60, T30) liegen an einem ersten und zweiten festen Potential (VDD, VSS),
- die gesteuerten Strecken des ersten und zweiten Transistors (T20, T50) liegen in Serie und der freie Anschluß des zweiten Transistors (T50) liegt am ersten festen Potential (VDD),
- die gesteuerten Strecken des dritten und vierten Transistors (T10, T40) liegen in Serie und der freie Anschluß des vierten Transistors (T40) liegt am zweiten festen Potential (VSS),
- der Gateanschluß des ersten Transistors (T20) ist mit der ersten Schreibleitung (W) verbunden,
- der Gateanschluß des dritten Transistors (T10) ist mit der zweiten Schreibleitung (W') verbunden,
c) zwischen einer Bitleitung (BL) und dem Gateanschluß des Transistorpaares (T30, T60) ist die gesteuerte Strecke des vierten Transistors (T70) mit der kleinen Kanalweite als Datentransfertransistor angeordnet, dessen Gateanschluß an eine Ansteuerschaltung (SW) angeschlossen ist.

5. Verfahren zum Einschreiben einer Information in die Speicherzelle (SZ2) nach Anspruch 4,
**gekennzeichnet** durch folgende Merkmale:
- an die Schreibleitungen (W, W') wird ein Signal angelegt, durch die das Transistorpaar (T30, T60) gesperrt wird,
- dann wird an die Ansteuerleitung (SW) ein Ansteuersignal angelegt, das den Datentransfertransistor (T70) leitend steuert und damit die Information auf der Bitleitung (BL) zum Speicherelement (SE2) durchschaltet,
- der Signalzustand auf den Schreibleitungen (W, W') wird so geändert, daß der erste Transistor (T20) und der dritte Transistor (T10) wieder leitend gesteuert wird,
- das Ansteuersignal auf der Ansteuerleitung (SE) wird entfernt und damit der Datentransfertransistor (T70) gesperrt.

6. Anordnung nach Anspruch 3,
dadurch **gekennzeichnet,**
- daß zur Erzeugung eines Festspeichers (ROM) pro Grundschaltung der Gateanschluß der Transistoren ohne gemeinsamen Gateanschluß in Abhängigkeit der zu speichernden Information mit einer Zeilenauswahlschaltung (ZLA) verbunden oder nicht verbunden ist,
- daß der eine Anschluß der gesteuerten Strecke der Transistoren mit einem festen Potential (VSS), der andere Anschluß der gesteuerten Strecke mit einer Spaltenleitung (SL) verbunden ist.

7. Anordnung nach Anspruch 6,

dadurch **gekennzeichnet,**

- daß der Source-Anschluß der zur Speicherung verwendeten Transistoren mit der Spaltenleitung (SL), der Drain-Anschluß mit dem festen Potential (VSS) verbunden ist, - daß der Gateanschluß der N-Kanaltransistoren mit einer Zeilenauswahlleitung (ZLA), auf der ein Zeilenauswahlsignal zum Auslesen anliegt, verbunden oder nicht verbunden ist,
- daß der Gateanschluß der P-Kanaltransistoren mit einer Zeilenauswahlleitung (ZLA'), auf der ein Zeilenauswahlsignal zum Auslesen invertiert anliegt, verbunden oder nicht verbunden ist.

8. Anordnung nach Anspruch 3, dadurch **gekennzeichnet,** daß zur Erzeugung eines Festspeichers die Gateanschlüsse der zur Speicherung verwendeten Transistoren mit Zeilenauswahlleitungen (ZLA, ZLA'), der Source-Anschluß dieser Transistoren in Abhängigkeit der zu speichernden Information an eine Spaltenleitung (SL) angeschlossen oder nicht angeschlossen ist und die Drain-Anschlüsse dieser Transistoren an einem festen Potential (VSS) liegen.

**Claims**

1. Gate array arrangement having the following features:
   - cell regions (ZB) are arranged in lines (ZL) and columns (SP), in the manner of a matrix, on a chip, the cell regions being located immediately adjacent to one another,
   - a basic circuit consisting of n-channel and p-channel transistors is constructed in each cell region (ZB),
   - each basic circuit consists of three transistors of the one conductance type (T20, T50, T60) and four transistors (T10, T30, T40, T70) of the opposite conductance type,
   - the three transistors of the one conductance type (T20, T50, T60) are located adjacent to one another in the line direction and have the same channel width,
   - three of the transistors (T10, T30, T40) of the opposite conductance type are located adjacent to one another in the line direction and have the same channel width,
   - in each case one transistor of the one conductance type and one transistor of the other conductance tee are located adjacent to one another in the column direction,
   - the fourth transistor (T70) of the opposite conductance type has a smaller channel width than the three transistors of the opposite conductance type (T10, T30, T40) and is located outside the region of the basic circuit occupied by the three transistors of the one conductance type and the three transistors of the opposite conductance type,
   - the respective transistors are connected to one another in pre-determined basic circuits, for specification according to the basic function to be implemented, as a logic cell or as a memory cell,
   - the basic circuits are wired to one another according to the overall function to be implemented, as a logic circuit or memory, and
   - the wiring of the basic circuits is carried out either via specified basic circuits or via non-specified basic circuits.

2. Arrangement according to Claim 1, characterised in that the transistors of the one conductance type are p-channel transistors, the transistors of the other conductance type being n-channel transistors.

3. Arrangement according to Claim 1 or 2, characterised in that the gate connections of one of the transistor pairs (T40, T50), located adjacent to one another in the column direction, are connected to one another.

4. Arrangement according to one of Claims 1 to 3, characterised by the following features:
   a) the transistors of at least one of the basic circuits are connected together into a memory cell (SZ2), consisting of a memory element (SE2) and a data transfer transistor (AS2),
   b) the memory element (SE2) consists of a transistor pair, comprising a p-channel transistor (T60) and an n-channel transistor (T30), and of a transistor circuit, comprising a first and second p-channel transistor (T20, T50) and a third and fourth n-channel transistor (T10, T40), which are connected as follows,
   - the common gate connection of the transistor pair (T30, T60) is connected to the connecting point (K1) of the controlled junctions of the first and third transistors (T10, T20),
   - the common gate connection of the second and fourth transistors (T40, T50) is connected to the connecting point of the controlled junctions of the transistor pair (T30, T60),

- the other connections of the controlled junctions of the transistor pair (T60, T30) are at first and second fixed potentials (VDD, VSS),

- the controlled junctions of the first and second transistors (T20, T50) are in series and the free connection of the second transistor (T50) is at the first fixed potential (VDD),

- the controlled junctions of the third and fourth transistors (T10, T40) are in series and the free connection of the fourth transistor (T40) is at the second fixed potential (VSS),

- the gate connection of the first transistor (T20) is connected to the first write line (W),

- the gate connection of the third transistor (T10) is connected to the second write line (W').

c) between a bit line (BL) and the gate connection of the transistor pair (T30, T60), there is arranged the controlled junction of the fourth transistor (T70), with the small channel width, as the data transfer transistor, whose gate connection is connected to a drive circuit (SW).

5. Method for writing an information item into the memory cell (SZ2) according to Claim 4, characterised by the following features:

- a signal is applied to the write lines (W, W'), as a result of which the transistor pair (T30, T60) is switched off,

- a drive signal is then applied to the drive line (SW), which drive signal switches the data transfer transistor (T70) on and hence switches the information item through onto the bit line (BL) to the memory element (SE2),

- the signal state on the write lines (W, W') is changed such that the first transistor (T20) and the third transistor (T10) are switched on again,

- the drive signal is removed from the drive line (SE) and hence the data transfer transistor (T70) is switched off.

6. Arrangement according to Claim 3, characterised in that,

- in order to produce one read only memory (ROM) per basic circuit, the gate connection of the transistors without a common gate connection is connected, or is not connected, to a line selection circuit (ZLA) as a function of the information item to be stored,

- the one connection of the controlled junction of the transistors is connected to a fixed potential (VSS), the other connection of the controlled junction being connected to a column line (SL).

7. Arrangement according to Claim 6, characterised in that,

- the source connection of the transistors used for storage is connected to the column line (SL), the drain connection being connected to the fixed potential (VSS),

- the gate connection of the n-channel transistors is connected or is not connected to a line selection line (ZLA), to which there is applied a line selection signal, for reading,

- the gate connection of the p-channel transistors is connected, or is not connected, to a line selection line (ZLA') to which there is applied a line selection signal in an inverted manner, for reading.

8. Arrangement according to Claim 3, characterised in that, to produce a read only memory, the gate connections of the transistors used for storage are connected, or are not connected, to line selection lines (ZLA, ZLA'), the source connection of these transistors is connected, or is not connected, to a column line (SL), as a function of the information item to be stored, and the drain connections of these transistors are at a fixed potential (VSS).

**Revendications**

1. Ensemble formé d'un réseau de portes présentant les caractéristiques suivantes :

- sur une microplaquette, des zones de cellules (ZB) sont disposées sous la forme d'une matrice suivant des lignes (ZL) et des colonnes (SP), et dans lequel les zones de cellules sont directement juxtaposées,

- dans chaque zone de cellule (ZB) est formé un circuit de base constitué par des transistors à canal N et des transistors à canal P,

- chaque circuit de base est constitué de trois transistors possédant un premier type de conductivité (T20,T50,T60) et quatre transistors (T10,T30,T40,T70) possédant le type de conductivité opposé,

- les trois transistors possédant le premier type de conductivité (T20,T50,T60) sont disposés côte-à-côte dans la direction des lignes et possèdent une même largeur de canal,

- trois des transistors (T10,T30,T40) possédant le type de conductivité opposé sont disposés côte-à-côte dans la direction des lignes et possèdent la même largeur de canal,
- respectivement un transistor possédant un premier type de conductivité et un transistor possédant l'autre type de conductivité sont disposés côte-à-côte dans la direction des colonnes,
- le quatrième transistor (T70) possédant le type de conductivité opposé possède une largeur de canal inférieure à celle des trois transistors (T10,T30,T40) possédant le type de conductivité opposé, et est situé à l'extérieur de la zone du circuit de base, qui est occupée par les trois transistors possédant le premier type de conductivité et par les transistors possédant le type de conductivité opposé,
- dans des circuits de base prédéterminés, les transistors respectifs sont raccordés entre eux pour la spécification conformément à la fonction de base devant être réalisée, en tant que cellule logique ou en tant que cellule de mémoire,
- les circuits de base sont connectés entre eux conformément à la fonction d'ensemble devant être réalisée, sous la forme d'un circuit logique ou d'une mémoire,
- la connexion des circuits de base est réalisée soit au moyen de circuits de base spécifiés, soit au moyen de circuits de base non spécifiés.

2.  Dispositif suivant la revendication 1, caractérisé par le fait que les transistors possédant le premier type de conductivité sont des transistors à canal p et les transistors possédant l'autre type de conductivité sont des transistors à canal n.

3.  Dispositif suivant la revendication 1 ou 2, caractérisé par le fait que les bornes de grille de l'un des couples de transistors (T40,T50) disposés côte-à-côte dans la direction des colonnes sont raccordées entre elles.

4.  Dispositif suivant l'une des revendications 1 à 3, caractérisé par les caractéristiques suivantes :

    a) les transistors d'au moins l'un des circuits de base sont interconnectés pour former une cellule de mémoire (SZ2) constituée par un élément de mémoire (SE2) et par un transistor de transfert de données (AS2),

    b) l'élément de mémoire (SE2) est constitué par un couple de transistors formé d'un transistor à canal P (T60) et d'un transistor à canal N (T30), et par un circuit à transistors constitué par des premier et second transistors à canal P (T20,T50) et des troisième et quatrième transistors à canal N (T10,T40), qui sont interconnectés de la manière suivante

    - la borne de grille commune du couple de transistors (T30,T60) est raccordée au point de jonction (K1) des voies commandées des premier et troisième transistors (T10,T20),
    - la borne de grille commune des second et quatrième transistors (T40,T50) est raccordée au point de jonction des voies commandées du couple de transistors (T30,T60),
    - les autres bornes de la voie commandée du couple de transistors (T60,T30) sont placées à des premier et second potentiels fixes (VDD,VSS),
    - les voies commandées des premier et second transistors (T20,T50) sont branchées en série, et la borne libre du second transistor (T50) est placée au premier potentiel fixe (VDD),
    - les voies de commande des troisième et quatrième transistors (T10,T40) sont branchées en série et la borne libre du quatrième transistor (T40) est placée au second potentiel fixe (VSS),
    - la borne de grille du premier transistor (T20) est raccordée au premier conducteur d'inscription (W1),
    - la borne de grille du troisième transistor (T10) est raccordée au second conducteur d'inscription (W'),

    c) entre un conducteur de transmission bits (BL) et la borne de grille du couple de transistors (T30,T60) est disposée la voie commandée du quatrième transistor (T70) qui possède une largeur de canal inférieure à celle du canal du transistor de transfert de données, dont la borne de grille est raccordée à un circuit de commande (SW).

5.  Procédé pour inscrire une information dans la cellule de mémoire (SZ2) suivant la revendication 4, caractérisé par les particularités suivantes :

    - un signal, qui place à l'état bloqué le couple de transistors (T30,T60), est appliqué aux conducteurs d'inscription (W,W'),

- ensuite le signal de commande, qui place à l'état conducteur le transistor de transfert de données (T70) et transmet par conséquent l'information présente dans le conducteur de transmission de bits (BL) à l'élément de mémoire (SE2), est appliqué au conducteur de commande (SW),
- l'état du signal présent dans les conducteurs d'inscription (W,W') est modifié de manière que le premier transistor (T20) et le troisième transistor (T10) sont à nouveau placés à l'état conducteur,
- le signal de commande présent dans le conducteur de commande (SE) est supprimé et le transistor de transfert de données (T70) passe à l'état bloqué.

6. Dispositif suivant la revendication 3, caractérisé par le fait
   - que pour la réalisation d'une mémoire fixe (ROM) pour chaque circuit de base, la borne de grille des transistors sans borne de grille commune est reliée ou n'est pas reliée, en fonction de l'information devant être mémorisée, à un circuit de sélection de ligne (ZLA), et
   - qu'une borne de la voie commandée des transistors est placée à un potentiel fixe (VSS) et que l'autre borne de la voie commandée est raccordée à un conducteur de colonnes (SL).

7. Dispositif suivant la revendication 6, caractérisé par le fait
   - que la borne de source des transistors utilisés pour la mémorisation est raccordée aux conducteurs de colonnes (SL) et que la borne de drain est placée à un potentiel fixe (VSS),
   - que la borne de grille des transistors à canal N est raccordée ou non raccordée à un conducteur de sélection de ligne (ZLA), dans lequel un signal de sélection de ligne est appliqué pour la lecture, et
   - que la borne de grille des transistors à canal P est raccordée ou non raccordée à un conducteur de sélection de lignes (ZLA'), dans lequel est présent un signal de sélection de ligne à l'état inversé pour la lecture.

8. Dispositif suivant la revendication 3, caractérisé par le fait que pour la réalisation d'une mémoire morte, les bornes de grille des transistors utilisés pour la mémorisation sont raccordées à des conducteurs de sélection de lignes (ZLA,ZLA'), que la borne de source de ces transistors est raccordée, en fonction de l'information devant être mémorisée, à un conducteur de colonnes (SL) et que les bornes de drain de ces transistors sont placées à un potentiel fixe (VSS).

**FIG 1**

**FIG 2**

**FIG 5**

11

# FIG 3

# FIG 4

# FIG 6

# FIG 7

SiNH$_3$

SiO$_2$

AL1    AL1    AL2

T2    T6    T4

p+    p+    p+    p+    n+

DIFF    DIFF    SKT

n

SU

# FIG 8

W

W'

BL

t

## FIG 9

## FIG 10

EP 0 224 887 B1

FIG 11

FIG 12

17

FIG 13

DATA

BT LV

BD

SZ2

W'
W

SW

WD

ADR

SZ2

BL

FIG 14

VDD

TE

SL

ZLA'

VSS

ZLA

TC

LV

VDD